# FASCICULE DE BREVET EUROPEEN

(11) **EP 3 005 244 B1**
(45) Date de publication et mention de la délivrance du brevet: **26.07.2023**
(21) Numéro de dépôt: 14729629.7
(22) Date de dépôt: 03.06.2014
(51) Int. Cl.: G06K 19/077

(54) **PROCEDE DE FABRICATION D'UN DISPOSITIF ELECTRONIQUE ANTI-FISSURATION**
HERSTELLUNGSVERFAHREN EINER REISSFESTEN ELEKTRONISCHEN VORRICHTUNG
METHOD FOR MANUFACTURING AN ANTI-CRACKING ELECTRONIC DEVICE

(30) Priorité: 07.06.2013 EP 13305764
(43) Date de publication de la demande: 13.04.2016
(73) Titulaire: Thales Dis France SAS, 92190 Meudon (FR)
(72) Inventeur: ALLOT, Francis, F-13705 La Ciotat (FR); LOMBARDO, Sophie, F-13705 La Ciotat (FR); LANKINEN, Mikko, F-13705 La Ciotat (FR); KAMAGATE, Youssiph, F-13705 La Ciotat (FR); BLACHON, Frédéric, F-13705 La Ciotat (FR)
(74) Mandataire: Milharo, Emilien
(86) Numéro de dépôt international: PCT/EP2014/061473
(87) Numéro de publication internationale: WO 2014/195308

(56) Documents cités:
- FR-A1- 2 601 477
- FR-A1- 2 861 201
- US-A- 5 975 420

## Description

### Domaine de l'invention.

L'invention concerne un procédé de fabrication d'un dispositif semi-fini (intermédiaire) et final, comportant notamment un corps-support avec cavité intégrant au moins une zone de connexion d'un circuit électrique / électronique.

L'invention concerne notamment le domaine des supports ou dispositifs électroniques radiofréquences tels que cartes à puce radiofréquences ou cartes hybrides, tickets ou étiquettes radiofréquences, passeports électroniques, transpondeurs radiofréquences, inserts (ou inlay) intégrant ou constituant de tels supports.

Ces supports électroniques trouvent application dans différents domaine de la carte à puce, en particulier pour des applications bancaires (EMV), d'identité, de sécurité, d'authentification, d'accès, de fidélité, passeport.

De tels supports électroniques peuvent être conformes notamment au standard ISO / IEC 14443 ou autre standard radiofréquence notamment NFC (Near field communication : champ radiofréquence de proximité)

Un module électronique peut constituer ou comprendre des plages conductrices de connexion ou d'interconnexion portées ou non, selon le cas, par un substrat isolant.

### Art antérieur.

Le brevet US 5 598 032 décrit un procédé d'assemblage d'un module destiné à se connecter à une antenne noyée dans un corps-support de carte à puce hybride (contact et sans contact), il est connu de ménager une cavité dans le corps-support de manière à rendre les zones de connexion de l'antenne accessibles pour une connexion avec le module lors de son report dans la cavité. Des éléments d'interconnexion conducteurs de toute sorte peuvent relier des plages de connexion du module disposées en dehors de l'enrobage et les zones de connexion de l'antenne.

Par ailleurs, il est connu de connecter ce type de module à une antenne localisée dans un corps de carte hybride contact et sans contact à l'aide de matière conductrice anisotropique au lieu de l'élément 24.

La demande de brevet FR 2861 201 décrit un procédé de fabrication d'une carte finie à double interface. Un module à contacts électriques externes est inséré dans une cavité du corps de carte finie et est connecté à des plages de connexion d'une antenne par adhésif anisotropique. Pour l'encartage du module dans la cavité, un jeu est nécessaire entre les bords du module et les parois de la cavité. Le jeu existant autour du module n'est pas recouvert ou destiné à être recouvert par dessus par une feuille de couverture.

Le document FR 2 601 477 décrit un procédé de fabrication d'une carte à puce à contacts finie. La carte à puce comprend un module avec des plages de contact sous la surface de la carte. Les plages de contact débouchent à la surface principale externe du corps de carte. L'élément 13 n'est pas une feuille de couverture au sens de l'invention.

Le document US5975420A décrit une carte à puce à contacts électriques affleurant la surface du corps de carte.

### Problème technique.

Actuellement, des couches de matériau fragiles utilisées comme feuille de couverture dans le corps de cartes à puce, peuvent être endommagées par des fissures qui naissent et se propagent dans la zone du module.

En outre, la connexion du module à une antenne de transpondeur disposée dans un corps support est relativement lente.

D'autre part, les assemblages existants de module dans un corps de carte peuvent donner lieu à des distorsions du support de puce (leadframe) provoquant des contraintes supplémentaires à la puce et fragilisant la fonctionnalité radiofréquence de l'ensemble.

### Résumé de l'invention.

L'invention prévoit une matière souple ou élastique qui bouche ou recouvre au moins partiellement les espaces ou interstices situés à l'interface entre le module et le corps support et adjacent de la surface du corps.

Grâce à l'invention, selon un aspect préféré, en une seule opération de connexion et une seule matière conductrice, l'invention permet de réaliser une fonction de connexion et une fonction anti-propagation de fissures après lamination. Une matière souple ou élastique (à température ambiante) disposée à l'intérieur des fentes, permet de bloquer ou de diminuer fortement les variations de largeur des fentes ; alternativement, en chevauchant les fentes, la matière absorbe des variations / contraintes évitant ainsi de les transmettre au feuilles de couverture.

En effet, après report et pressage à chaud ou lamination, la matière conductrice flue dans les interstices. Dans le cas de l'ACF, la connexion s'effectue dans une direction perpendiculaire au plan principal du support et il n'y a pas de risque de court-circuit entre les zones de connexion du module.

Selon un autre aspect, l'invention prévoit un « patch » (pièce fine en matière souple ou élastique sous forme de film ou de pâte), qui s'étend sensiblement autour ou à l'aplomb de la zone du module rapportée au niveau de la fabrication de l'insert radiofréquence semi-fini.

La pièce souple ou élastique peut être en contact ou non avec le module ou puce pour éviter la propagation des fissures dans le corps final, soit par absorption des contraintes, soit par découplage mécanique du module avec les feuilles de couverture.

L'invention a pour objet un procédé de fabrication d'un dispositif électronique selon la revendication 1.

Selon d'autres caractéristiques ou modes de mise en oeuvre du dispositif ;
- La matière conductrice est de type anisotropique ;
- La matière anisotropique entoure le module ;
- Le dispositif comprend un patch (35), en matière souple ou élastique recouvrant l'interface ;
- Le dispositif comprend au moins une feuille de couverture (38)) dessus ou dessous ledit patch ;

L'invention a également pour objet un dispositif correspondant au procédé.

### Brève description des figures.

- Les figures 1 et 2 illustrent un exemple de module de carte à puce de circuit intégré hybride de l'art antérieur ;
- Les figures 3 et 4 illustrent une étape d'un premier mode de réalisation de l'invention respectivement en vue de dessus et en coupe A-A de la figure 4 ;
- Les figures 5A, 5B et 6 illustrent un module utilisable par l'invention avec deux répartitions différentes de la colle conductrice sur le module ;
- La figure 7 illustre le dispositif de la figure 3 après pressage à chaud ;
- La figure 8 illustre le même dispositif que celui de la figure 7 (en plus gros plan) additionné de feuilles de couvertures ;
- Les figures 9 et 10 illustrent un second et troisième mode de réalisation de l'invention.

### Description.

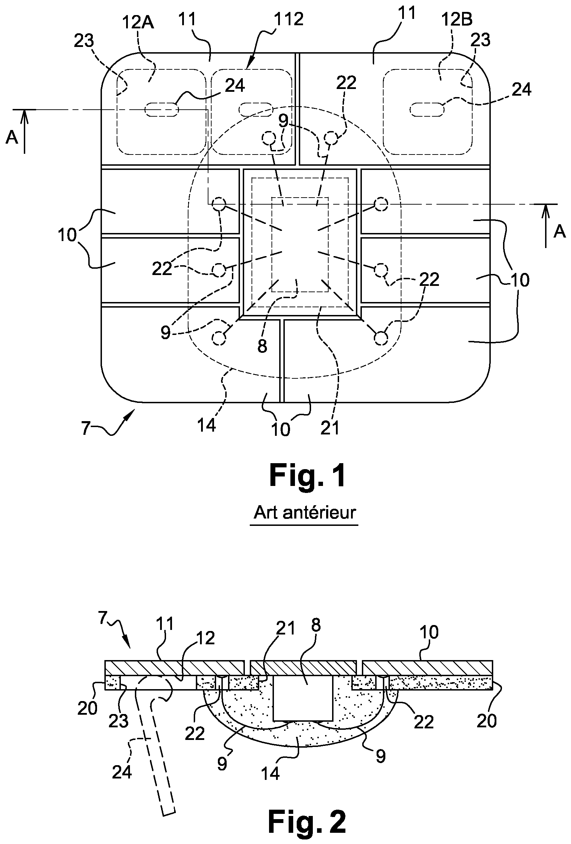

Les figures 1 et 2 illustrent un exemple de module 7 de carte à puce de circuit intégré hybride de l'art antérieur. Le module 7 comprend des plages de contact 10, 11 sur un support 20 diélectrique ou isolant notamment du type LFCC (Lead frame contrecollé), au moins une puce de circuit intégré 8 reportée sur le support 20 ou ici sur une plage métallique de contact ou non. Les plages de contact sont destinées à connecter un connecteur de lecteur de carte à puce.

Le module comprend également des connexions 9 pour notamment connecter des plages de contact par fils soudés, par colle conductrice ou autre, une puce électronique 8 (ici de type hybride) pouvant être retournée (flip-chip) ou non ; il comprend un enrobage 14 de la puce et/ou de ses connexions par une matière de protection telle une résine (glob-top) .

Les connexions 9 peuvent connecter les plages de contact à travers des orifices 22 ménagés dans le support isolant.

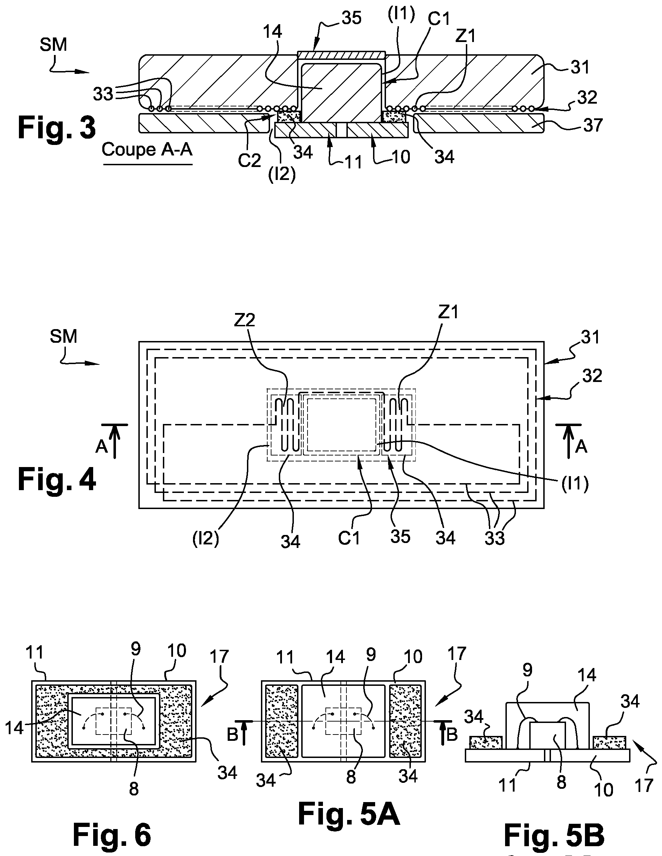

En relation avec les figures 3 à 9, on décrit un procédé de fabrication d'un dispositif électronique SM qui peut être provisoire ou définitif ; le dispositif (SM) comporte selon un premier mode de réalisation / mise en oeuvre de l'invention, une étape d'assemblage.

L'assemblage de cet exemple comporte un corps-support (31, 32) muni d'une cavité (C1, C2) et d'un circuit électrique (32) comportant au moins une zone d'interconnexion (Z1, Z2) électrique à l'intérieur de la cavité. Le dispositif comporte également dans la cavité, un module électronique /électrique (17) comportant au moins une plage de connexion (10, 11) et présentant une interface ou délimitation (I1, I2) entre le module et la paroi de la cavité ; il comporte également une matière conductrice (34) souple pour connecter ladite plage de connexion du module à ladite zone d'interconnexion (Z1, Z2).

L'interface entre le module et le corps-support définit ici deux interstices I1, I2, orientés perpendiculairement aux surfaces principales opposées du corps-support et débouchant du corps-support.

Le corps-support peut être obtenu par exemple par moulage ou superposition de feuilles. Dans l'exemple, le dispositif est une carte purement sans-contact (radiofréquence) ayant comme circuit électrique une antenne radiofréquence 32 connectée à un module radiofréquence 17. Toutefois, le dispositif peut être alternativement un passeport électronique, une clé radiofréquence (ou NFC), un circuit imprimé, un lecteur radiofréquence, une étiquette RFID, tout objet électronique.

Dans l'exemple de la figure 3, le circuit est une antenne radiofréquence 32 composée ici de spires 33 formées sur un substrat 31 par tout moyen connu, notamment par sérigraphie, jet de matière conductrice, technique d'électrodéposition, gravure. Dans l'exemple, l'antenne est en fil incrusté par technique ultrasons sur la surface principale du substrat 31 notamment en matière plastique connue (ABS, PC, PET) ou fibreuse. Pour d'autres fréquences radiofréquences (notamment UHF), l'antenne peut présenter une forme différente des spires planes. Les zones de connexion de l'antenne sont formées par des zigzags (ou alternances rapprochés) de fils conducteurs.

L'antenne comporte des zones de connexion ou d'interconnexion Z1, Z2 espacées d'une distance correspondant aux deux plages de connexion 10, 11 du module radiofréquence (ou plots de connexion de la puce).

Dans le cas où, comme dans l'exemple, les plages sont constituées de fils conducteurs recouverts d'isolant, ce dernier peut être supprimé à l'endroit de la connexion par tout moyen connu notamment mécanique, usinage ou par laser, attaques chimiques ou thermiques.

Le substrat 31 est ici assemblé avec une feuille de compensation 37 recouvrant l'antenne. Cette feuille de compensation d'épaisseur 37 comporte une perforation ou cavité C2 centrée sur une perforation ou cavité C1 du substrat ménagée entre les zones de connexion de l'antenne.

Par ailleurs, le procédé utilise un module radiofréquence comprenant une puce radiofréquence (laquelle peut être alternativement hybride).

Le module comprend ici deux plages de connexion 10, 11 (sans support diélectrique) reliées à la puce 8 par une connexion notamment filaire 9, un enrobage 14 comme précédemment.

Selon une caractéristique de l'invention, la matière conductrice est agencée et compressée dans le dispositif de manière à fluer dans l'interface et remplir au moins partiellement l'interface (I2).

Dans l'exemple, un matériau conducteur (ou matière conductrice) 34 est placé entre les zones de connexion de l'antenne et celle du module (ou plots de la puce) avant d'effectuer la connexion par report du module.

Selon un avantage de l'invention, le matériau conducteur possède la propriété d'être plus souple que les feuilles de couverture à la température d'utilisation du produit électronique (notamment entre - 15 °C et 60 °C).

Cependant de préférence, on peut utiliser un matériau anisotropique, sous forme de film (ACF) ou de pâte (ACP) ou une résine conductrice souple (la souplesse étant supérieure de préférence à celle des feuilles de couverture) dans le même environnement notamment de température, pression.

Par exemple, sur les figures 5A, 5B, 6, le matériau conducteur 34 peut être disposé (agencé) ou laminé sur les plages de connexion du module (ou puce). Sur les figures 5A, 5B, le matériau est disposé sur chaque plage de connexion. Sur la figure 6, le matériau 34 en forme d'anneau entoure l'enrobage. L'épaisseur (ou volume) du matériau conducteur est calculée pour permettre un fluage du matériau dans les interstices environnants le module après assemblage final avec le corps du dispositif.

Puis le module 17 est reporté contre l'antenne, pressé et chauffé au moins sur cette zone de contact pour établir la connexion avec les plages de contact de l'antenne, la compression et le fluage de la matière conductrice dans les interstices (I1 voir I2) environnant le module, situés à l'interface entre le module et le corps du dispositif et orientés sensiblement perpendiculairement à la surface principale du corps-support.

Alternativement, le matériau conducteur 34 peut être appliqué directement sur les zones de connexion Z1, Z2 de l'antenne ; ensuite le module (ou puce) est reporté contre l'antenne, pressé et chauffé au moins sur cette zone de connexion.

Pour cette étape, deux options ci-après sont possibles. Les dimensions du film conducteur (ou pâte, matière électriquement conductrice) peuvent être ajustées aux zones de connexion de l'antenne et/ou du module. Alternativement, les dimensions du film conducteur électrique peuvent être ajustées aux dimensions du module (ou puce).

Accessoirement aussi, avant un pressage à chaud, on peut disposer un patch ou pièce de matériau élastique thermo fusible 35 contre l'arrière du module, ici contre l'enrobage 14. Ce patch recouvre dans l'exemple, toute la surface de la cavité C1 et l'interstice I1 existant entre la cavité et l'enrobage 14. Ce patch est destiné à absorber des contraintes pouvant naître à l'interface du module avec le corps-support (ou substrat) et stopper d'éventuelles propagations de fissures à toute feuille de couverture (ou couche de matière) recouvrant le corps-support 31.

Un pressage à chaud peut être réalisé au cours du report du module mais il est de préférence réalisé ultérieurement au cours d'une lamination à chaud du dispositif une fois assemblé avec des plaques ou feuilles de couverture et autre patch ou pièce d'anti-fissure comme expliqué ultérieurement. De préférence, l'assemblage s'effectue sur des plaques ou feuilles de grande dimension comportant une pluralité de modules et d'antennes de circuits électriques / électroniques. Le substrat 31 peut aussi être sous forme de bande continue, le dispositif final étant ensuite extrait par découpe du d'un substrat comportant une pluralité de dispositifs formés ensemble.

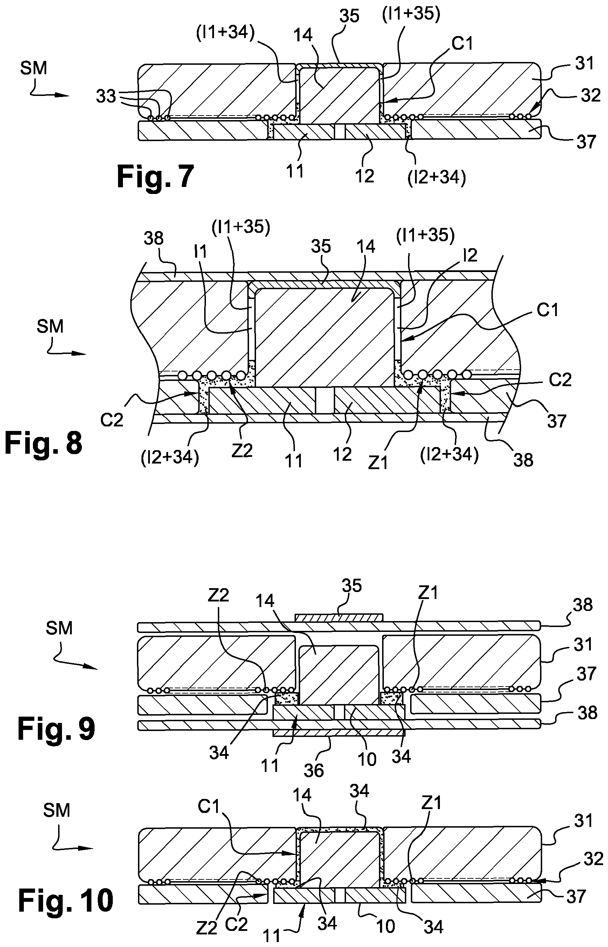

A la figure 7, le dispositif semi-fini SM est obtenu par lamination à chaud. Les interstices (I1, I2) présents entre le module 17 et la paroi interne des cavités C1, C2 sont au moins partiellement (ou en totalité) remplis par la matière conductrice élastique 34 qui a flué dedans au cours de la lamination.

Ainsi, ces interstices, responsables de la génération de fissures sur les feuilles de couverture recouvrant le corps 31 et/ou 37, peuvent être colmatés au moins partiellement avec la même matière conductrice servant à la connexion électrique du module.

Selon un aspect préféré, l'opération de connexion du module à l'antenne et l'opération de comblement au moins partiel des interstices environnant le module peuvent avantageusement s'effectuer par lamination à chaud de l'ensemble.

Par ailleurs, l'interstice I1 à l'arrière du module peut le cas échéant, être également comblé par un « patch » arrière 35 qui a aussi flué dedans.

La surface arrière de l'enrobage peut également comporter la matière élastique 35 pour absorber des compressions du module vers la surface arrière du substrat (survenant notamment au cours de flexion / torsion du dispositif final.

Ainsi, le module peut être entouré ou recouvert au moins partiellement de matière élastique absorbant les contraintes mécaniques et évitant une propagation de fissures aux feuilles de couverture.

A la figure 8, l'invention prévoit une construction similaire à la figure précédente mais avec en plus des feuilles de couverture laminées sur le dispositif SM de part et d'autre du dispositif.

A la figure 9, l'invention prévoit une construction similaire à la figure 8, à la différence que le patch 35 élastique (absorbant) est disposé à l'extérieur de la feuille de couverture recouvrant le substrat 31 du côté de l'enrobage.

Le cas échéant, ce second mode de réalisation peut comporter un autre patch élastique et thermo fusible 36 à l'aplomb des plages de contact du module ou de la cavité C2 de la feuille de compensation.

A la figure 10, la construction est similaire à celle de la figure 3 sauf que la matière conductrice 34 et le patch arrière 35 sont formés à partir d'une même pièce.

Deux procédés peuvent être envisagés. Le premier consiste à recouvrir le module d'un chapeau ou d'une bande de matière conductrice 34 recouvrant les plages de contact et l'arrière de l'enrobage avant de reporter le module ainsi coiffé dans les cavités C1 et C2. Le second peut consister à placer une portion de feuille ou pièce dans la cavité C2 et de reporter ensuite par-dessus le module qui vient déformer la pièce 34 au fur et à mesure de l'insertion du module dans la cavité C1.

Ainsi, avec la même matière conductrice 34, on vient effectuer la connexion du module à l'antenne et combler au moins en partie l'interstice situé entre l'enrobage et la cavité.

Cette matière conductrice assure également la fonction anti propagation de fissure du patch 35 à l'arrière du module.

## Revendications

1. Procédé de fabrication d'un dispositif électronique intermédiaire (SM) recouvert d'une feuille ou couche de couverture sur toute sa surface principale, ledit procédé comportant une étape de formation d'un corps-support (31, 32) comportant :
- une cavité (C1, C2) ménagée dans le corps-support,
- une antenne (32) comportant au moins une zone d'interconnexion (Z1, Z2) électrique à l'intérieur de la cavité,
- un module électronique (17) comportant au moins une plage de connexion (10, 11) connectant ladite zone d'interconnexion, disposé dans la cavité
- un espace ou interstice (I1, I2) existant à l'interface entre le module et le corps-support, orienté sensiblement perpendiculairement à ladite surface principale du corps-support, débouchant en surface du corps-support et étant destiné à être recouvert de ladite feuille ou couche de couverture,
**caractérisé en ce qu'**une matière souple ou élastique est agencée dans le dispositif de manière à remplir ou recouvrir au moins partiellement ledit espace ou interstice entre le module et le corps-support,
et **en ce que** la matière souple comprend une matière conductrice de connexion agencée et compressée dans le dispositif de manière à connecter le module à l'antenne et à fluer dans ledit espace ou interstice pour le remplir au moins partiellement.

2. Procédé selon la revendication précédente, **caractérisé en ce que** la matière conductrice est de type anisotropique.

3. Procédé selon la revendication précédente, **caractérisé en ce que** la matière anisotropique entoure le module.

4. Procédé selon la revendication précédente, **caractérisé en ce que** ledit dispositif comprend un patch (35), en matière souple ou élastique recouvrant l'interface.

5. Procédé selon la revendication précédente, **caractérisé en ce que** ladite feuille de couverture (38) est dessus ou dessous ledit patch ou de l'interstice.

6. Dispositif électronique (SM) intermédiaire (SM)recouvert d'une feuille ou couche de couverture sur toute sa surface principale, ledit dispositif comportant :
- un corps-support (31, 32)
- une cavité (C1, C2) ménagée dans le corps-support,
- une antenne (32) comportant au moins une zone d'interconnexion (Z1, Z2) électrique à l'intérieur de la cavité,
- un module électronique (17) comportant au moins une plage de connexion (10, 11) connectant ladite zone d'interconnexion, disposé dans la cavité
- un espace ou interstice (I1, I2) existant à l'interface entre le module et le corps-support, orienté sensiblement perpendiculairement à ladite surface principale du corps-support et débouchant en surface du corps-support et étant destiné à être recouvert de ladite feuille ou couche de couverture,
**caractérisé en ce qu'**il comprend une matière souple ou élastique agencée de manière à remplir ou recouvrir au moins partiellement ledit espace ou interstice entre le module et le corps-support,
et **en ce que** la matière souple comprend une matière conductrice de connexion agencée et compressée dans le dispositif de manière à connecter le module à l'antenne et à fluer dans ledit espace ou interstice pour le remplir au moins partiellement.

7. Dispositif selon la revendication précédente, **caractérisé en ce que** la matière conductrice est anisotropique.

## Patentansprüche

1. Verfahren zur Herstellung einer zwischengeschalteten elektronischen Vorrichtung (SM), die auf ihrer gesamten Hauptoberfläche mit einer Deckfolie oder -schicht bedeckt ist, wobei das Verfahren einen Schritt des Ausbildens eines Trägerkörpers (31, 32) beinhaltet, der Nachfolgendes aufweist:
- einen Hohlraum (C1, C2), der sich im Trägerkörper befindet,
- eine Antenne (32), die mindestens einen Bereich zum elektrischen Zusammenschalten (Z1, Z2) im Inneren des Hohlraums aufweist,
- ein Elektronikmodul (17) mit mindestens einer den Zusammenschaltbereich verbindenden Verbindungsfläche (10, 11), das in dem Hohlraum angeordnet ist
- einen Zwischenraum oder Spalt (11, 12), der sich an der Grenzfläche zwischen dem Modul und dem Trägerkörper befindet, im Wesentlichen senkrecht zu der Hauptoberfläche des Trägerkörpers ausgerichtet ist, in die Oberfläche des Trägerkörpers mündet und von der Deckfolie oder -schicht bedeckt werden soll,
**dadurch gekennzeichnet, dass** ein weiches oder elastisches Material derart in der Vorrichtung angeordnet wird, dass der Zwischenraum oder Spalt zwischen dem Modul und dem Trägerkörper mindestens teilweise ausgefüllt oder bedeckt wird,
und **dass** das weiche Material ein leitfähiges Verbindungsmaterial umfasst, das derart in der Vorrichtung angeordnet und eingedrückt wird, dass das Modul mit der Antenne verbunden wird und es derart in den Zwischenraum oder Spalt fließt, dass er diesen mindestens teilweise ausfüllt.

2. Verfahren nach dem vorstehenden Anspruch, **dadurch gekennzeichnet, dass** es sich bei dem leitfähigen Material um ein anisotropes Material handelt.

3. Verfahren nach dem vorstehenden Anspruch, **dadurch gekennzeichnet, dass** das anisotrope Material das Modul umgibt.

4. Verfahren nach dem vorstehenden Anspruch, **dadurch gekennzeichnet, dass** die Vorrichtung einen Patch (35) aus weichem oder elastischem Material umfasst, der die Grenzfläche bedeckt.

5. Verfahren nach dem vorstehenden Anspruch, **dadurch gekennzeichnet, dass** die Deckfolie (38) über oder unter dem Patch oder dem Spalt ist.

6. Zwischengeschaltete (SM) elektronische Vorrichtung (SM), die auf ihrer gesamten Hauptoberfläche mit einer Deckfolie oder -schicht bedeckt ist, wobei die Vorrichtung Folgendes aufweist:
- einen Trägerkörper (31, 32)
- einen Hohlraum (C1, C2), der sich im Trägerkörper befindet,
- eine Antenne (32), die mindestens einen Bereich zum elektrischen Zusammenschalten (Z1, Z2) im Inneren des Hohlraums aufweist,
- ein Elektronikmodul (17) mit mindestens einer den Zusammenschaltbereich verbindenden Verbindungsfläche (10, 11), das in dem Hohlraum angeordnet ist
- einen Zwischenraum oder Spalt (11, 12), der sich an der Grenzfläche zwischen dem Modul und dem Trägerkörper befindet, im Wesentlichen senkrecht zu der Hauptoberfläche des Trägerkörpers ausgerichtet ist und in die Oberfläche des Trägerkörpers mündet und von der Folie oder Schicht bedeckt werden soll,
**dadurch gekennzeichnet, dass** sie ein biegbares oder elastisches Material umfasst, das derart angeordnet ist, dass der Zwischenraum oder Spalt zwischen dem Modul und dem Trägerkörper mindestens teilweise ausgefüllt oder bedeckt wird,
und **dass** das weiche Material ein leitfähiges Verbindungsmaterial umfasst, das derart in der Vorrichtung angeordnet und eingedrückt wird, dass das Modul mit der Antenne verbunden wird und es derart in den Zwischenraum oder Spalt fließt, dass er diesen mindestens teilweise ausfüllt.

7. Vorrichtung nach dem vorstehenden Anspruch, **dadurch gekennzeichnet, dass** das leitfähige Material anisotrop ist.

## Claims

1. A method for manufacturing an intermediate electronic device (SM) covered with a cover sheet or layer over its entire main surface, said method comprising a step of forming a support body (31, 32) comprising:
- a cavity (C1, C2) provided in the support body,
- an antenna (32) comprising at least one electrical interconnection zone (Z1, Z2) inside the cavity,
- an electronic module (17) comprising at least one connection pad (10, 11) connecting said interconnection zone, which module is arranged in the cavity,
- a space or gap (11, 12) existing at the interface between the module and the support body, which space or gap is oriented substantially perpendicularly to said main surface of the support body, opens out at the surface of the support body and is intended to be covered with said cover sheet or layer,
**characterized in that** a flexible or elastic material is arranged in the device so as to at least partially fill or cover said space or gap between the module and the support body,
and **in that** the flexible material comprises a conductive connection material arranged and compressed in the device so as to connect the module to the antenna and to flow into said space or gap in order to at least partially fill it.

2. The method according to the preceding claim, **characterized in that** the conductive material is anisotropic.

3. The method according to the preceding claim, **characterized in that** the anisotropic material surrounds the module.

4. The method according to the preceding claim, **characterized in that** said device comprises a patch (35) made of a flexible or elastic material covering the interface.

5. The method according to the preceding claim, **characterized in that** said cover sheet (38) is above or below said patch or the gap.

6. An intermediate (SM) electronic device (SM) covered with a cover sheet or layer over its entire main surface, said device comprising:
- a support body (31, 32),
- a cavity (C1, C2) provided in the support body,
- an antenna (32) comprising at least one electrical interconnection zone (Z1, Z2) inside the cavity,
- an electronic module (17) comprising at least one connection pad (10, 11) connecting said interconnection zone, which module is arranged in the cavity,
- a space or gap (11, 12) existing at the interface between the module and the support body, which space or gap is oriented substantially perpendicularly to said main surface of the support body, opens out at the surface of the support body and is intended to be covered with said cover sheet or layer,
**characterized in that** it comprises a flexible or elastic material arranged so as to at least partially fill or cover said space or gap between the module and the support body,
and **in that** the flexible material comprises a conductive connection material arranged and compressed in the device so as to connect the module to the antenna and to flow into said space or gap in order to at least partially fill it.

7. The device according to the preceding claim, **characterized in that** the conductive material is anisotropic.
